# EUROPÄISCHE PATENTSCHRIFT

(11) **EP 3 538 903 B1**
(45) Veröffentlichungstag und Bekanntmachung des Hinweises auf die Patenterteilung: **06.10.2021**
(21) Anmeldenummer: 17734264.9
(22) Anmeldetag: 19.06.2017
(51) Int. Cl.: G01R 22/10

(54) **MESSWANDLER**
MEASURING TRANSDUCER
TRANSFORMATEUR DE MESURE

(30) Priorität: 08.11.2016 DE 102016121334
(43) Veröffentlichungstag der Anmeldung: 18.09.2019
(73) Patentinhaber: Innogy SE, 45128 Essen (DE)
(72) Erfinder: WAFFNER, Jürgen, 45307 Essen (DE); VOIT, Stephan, 44892 Bochum (DE)
(74) Vertreter: Cohausz & Florack
(86) Internationale Anmeldenummer: PCT/EP2017/064920
(87) Internationale Veröffentlichungsnummer: WO 2018/086770

(56) Entgegenhaltungen:
- WO-A1-2010/149450
- US-A- 5 574 362
- US-A1- 2011 285 349

## Beschreibung

Der Gegenstand betrifft einen Messwandler für Elektrofahrzeuge sowie ein Verfahren zum Betreiben eines Messwandlers.

Durch die zunehmende Verbreitung von elektrischen Ladestationen für Elektrofahrzeuge ergeben sich neue Herausforderungen hinsichtlich der einzusetzenden Messtechnik. Insbesondere sind technische Herausforderungen im Hinblick auf die korrekte Abrechnung von bezogener elektrischer Energie zu bewältigen. Dies gilt insbesondere für das induktive Laden von Elektrofahrzeugen. Geeignete Messtechnik sollte beim induktiven Laden in dem Elektrofahrzeug angeordnet sein, um die tatsächlich von dem Energiespeicher bezogene Energie bestimmten zu können. Dies ist vor allem beim induktiven Laden von Bedeutung, da die Verlustleistung auf dem Übertragungsweg beachtlich ist.

Aus diesem Grunde lag dem Gegenstand die Aufgabe zu Grunde, eine verlässliche, in hoher Stückzahl verfügbare Messtechnik für das induktive Laden zur Verfügung zu stellen.

Diese Aufgabe wird gegenständlich durch ein Elektrofahrzeug nach Anspruch 1, eine Ladestation nach Anspruch 14 sowie ein Verfahren nach Anspruch 15 gelöst.

Gegenständlich wird in dem Elektrofahrzeug in einem Wechselstromladekreis, der durch eine Induktionsspule gespeist wird und zum Laden eines Energiespeichers des Fahrzeugs genutzt wird, die zur Verfügung gestellte elektrischen Leistung in einem Wechselstromesskreis mit Normmesstechnik für Abrechnungszwecke gemessen.

Es ist erkannt worden, dass in herkömmlichen Wechselstromladekreisen für das Laden von Elektrofahrzeugen in der Regel weder Normspannungen noch Normfrequenzen zum Einsatz kommen. Bei der induktiven Ladung wird über eine induktive Kopplung zwischen einer Spule in einer Ladestation und einer Induktionsspule in dem Elektrofahrzeug ein elektrisches Wechselfeld in der Induktionsspule induziert. An der Induktionsspule liegt abhängig von der Kopplung, der Windungszahl, der Frequenz und der Spannung an der Spule in der Ladestation eine Wechselspannung an, die den Wechselstromladekreis speist. Diese Wechselspannung wird in dem Fahrzeug mittels Gleichrichter in eine Gleichspannung gewandelt, die zum Laden des Energiespeichers genutzt wird. Zu Abrechnungszwecken ist jedoch eine Messung in dem Wechselstromladekreis bevorzugt.

Da aber weder Normspannung noch Normfrequenz im Wechselstromladekreis anliegen, ist ein Messen der elektrischen Leistung bisher nicht mit Normmesstechnik möglich. Normmesstechnik hat aber den Vorteil, dass deren Funktion jahrzehntelang nachgewiesen ist, dass sie in großen Stückzahlen verfügbar ist und eichrechtlich bereits zugelassen ist. Um die Normmesstechnik verwenden zu können, wird der gegenständliche Messwandler vorgeschlagen, der die Wechselstrommessgröße in dem Wechselstrommesskreis in zumindest eine Wechselstromgröße bei einer Normfrequenz wandelt. Normmesstechnik arbeitet in der Regel bei einer Normfrequenz von 50Hz bzw. 60Hz, je nach Versorgungsnetz. Diese Normfrequenz wird in der Messtechnik angenommen, um aus den gemessenen Größen wie Stromstärke und Spannung eine elektrische Leistung und über die Zeit eine elektrische Energie zu bestimmen.

Um die Messung mit Normmesstechnik zu ermöglichen, umfasst der Messwandler zunächst einen Abgriff zum Abgreifen einer Wechselstromgröße in einem Wechselstromladekreis. Der Wechselstromladekreis ist insbesondere der Stromkreis in dem Elektrofahrzeug, der an die Induktionsspule zum induktiven Koppeln mit einer Ladestation angeschlossen ist. Dann wird die Leistung fahrzeugseitig gemessen. Der Wechselstromladekreis kann aber auch insbesondere der Stromkreis mit der Induktionsspule der Ladestation sein. Dann wird die Leistung ladestationsseitig gemessen. In dem Wechselstromladekreis fließt ein Wechselstrom, der fahrzeugseitig durch die induktive Kopplung mit der Ladestation induziert ist. Die Frequenz des Wechselstroms ist jedoch abhängig von der Ladetechnik und in den seltensten Fällten eine Normfrequenz. Aus diesem Grunde weist der Messwandler ferner einen Wandler eingerichtet zum Umsetzen einer Frequenz der Wechselstrommessgröße in eine Normfrequenz eines Energieversorgungsnetzes auf.

Darüber hinaus verfügt der Wandler über eine Ausgabe, die in einen von dem Wechselstromladekreis getrennten Wechselstrommesskreis eine Wechselstrommessgröße einkoppelt, die über Normfrequenz verfügt. Beispielsweise wird das Laden mit einer Frequenz von mehr als 100 Hz durchgeführt. Mittels des Wandlers wird dann die Frequenz von 100 Hz auf 50 Hz gestellt und in dem Wechselstrommesskreis wird eine Wechselstromgröße eingekoppelt, die eine Frequenz von beispielsweise 50 Hz hat. Bei der Frequenzumsetzung wird natürlich auch darauf geachtet, dass die aufgrund der Wechselstromgröße dann mit dem Normmesszähler gemessene elektrische Leistung zu der elektrischen Leistung in dem Wechselstromladekreis korrespondiert. Insbesondere wird die Phasenlage der Messgrößen berücksichtigt, so dass die Wirkleistung in dem Wechselstrommesskreis zu der Wirkleistung in dem Wechselstromladekreis korrespondiert.

Durch das Ausgeben der Wechselstromgröße mit Normfrequenz ist es möglich, dass der Messwandler mit zumindest einem im Wechselstrommesskreis angeordneten Normmesszähler eine elektrische Leistung erfassen kann. Die elektrische Leistung wird über die Wechselstromgröße bei der Normfrequenz erfasst und korrespondiert durch geeignete Skalierung zu der elektrischen Leistung in dem Wechselstromladekreis.

Wie bereits erläutert, wird der Messwandler vorzugsweise in Wechselstromladekreisen eingesetzt, die über eine Induktionsspule gespeist werden bzw. eine Erregerspule speisen. Wenn nachfolgend von Induktionsspule bzw. Erregerspule die Rede ist, sind diese Begriffe soweit sinnvoll, miteinander austauschbar. Insbesondere kann der Messwandler zum Laden und zum Rückspeisen genutzt werden. Beim Laden ist die Induktionsspule in dem Fahrzeug und die Erregerspule an der Ladestation, beim Rückspeisen ist die Erregerspule am Fahrzeug und die Induktionsspule an der Ladestation. Beide Funktionen lassen sich mit dem gegenständlichen Messwandler abbilden. Beim Rückspeisen ist der Ladekreis als Speisekreis für das Energieversorgungsnetz zu verstehen.

Eine Induktionsspule ist gemäß Ausführungsbeispiel in dem Wechselstromladekreis vorgesehen. Die Induktionsspule dient in dem Wechselstromladekreis als Spannungsquelle, insbesondere als Konstantspannungsquelle. Die an den Abgriffen der Induktionsspule anliegende Spannung ist vorzugsweise abhängig von der Wicklungszahl der Induktionsspule, der Wicklungszahl der Spule in der Erregerspule sowie der Eingangsspannung an der Erregerspule. Ferner können auch noch Abhängigkeiten aufgrund der Frequenz der Eingangsspannung an der Erregerspule bestehen.

Gemäß einem Ausführungsbeispiel wird vorgeschlagen, dass der Wandler eine Wechselstromstellgröße zumindest abhängig von der Wechselstrommessgröße einstellt. Der Wechselstrommesskreis wird vorzugsweise über eine Konstantstromquelle oder eine Konstantspannungsquelle betrieben und über einen definierten Messwiderstand wird ein Spannungsabfall gemessen. Zum Einprägen der Wechselstromgröße in den Wechselstrommesskreis wird die Wechselstromstellgröße verwendet, die in dem Wandler zur Einstellung der Konstantstromquelle und/oder der Konstantspannungsquelle verwendet wird.

Gemäß einem Ausführungsbeispiel wird vorgeschlagen, dass der Wandler derart eingerichtet ist, dass der Betrag der Wechselstromgröße um zumindest einen Faktor 10 kleiner ist als der Betrag der Wechselstrommessgröße. Um die Verlustleistung in dem Wechselstrommesskreis so gering wie möglich zu halten, ist es vorteilhaft, wenn der Betrag der Wechselstromgröße geringer ist, als der Betrag der Wechselstrommessgröße, vorzugsweise zumindest um einen Faktor 10. Dann fällt über den Messwiderstand im dem Wechselstrommesskreis nur sehr wenig Leistung ab und der Wechselstrommesskreis kann mit einer Verlustleistung betrieben werden, die ebenfalls um einen Faktor 10 oder mehr geringer ist, als die Verlustleistung auf der Übertragungsstrecke zwischen der Erregerspule und der Induktionsspule. Dies ist insofern wichtig, als die Messtechnik möglichst geringe Verlustleistung aufweisen sollte.

Gemäß einem Ausführungsbeispiel wird vorgeschlagen, dass die zumindest eine Wechselstrommessgröße zumindest eine Wechselspannung und/oder einen Wechselstrom umfasst. Über einen Messwiderstand im Wechselstromladekreis kann eine Spannung abgegriffen werden und parallel zum Energiespeicher kann eine weitere Spannung abgegriffen werden. Die Spannung über den Messwiderstand ist vorzugsweise proportional zu dem Strom in dem Wechselstromladekreis, so dass über den Messwiderstand ein Wechselstrom erfasst werden kann. Der erfasste Wechselstrom zusammen mit der Wechselspannung kann, insbesondere abhängig auch von deren Phasenlage zueinander, für das Bestimmen der Wirkleistung in dem Wechselstromladekreis genutzt werden. Die Ausgabe der Wechselstromgrößen, wie Wechselspannung und Wechselstrom im Wechselstrommesskreis erfolgt bei Normfrequenz.

Wie bereits erwähnt, ist die elektrische Wirkleistung wesentlich für die Abrechnung der bezogenen Energie. Aus diesem Grunde wird die elektrische Leistung in dem Wechselstrommesskreis als elektrische Wirkleistung erfasst. Hierbei spielen insbesondere die Phasenwinkel zwischen den Wechselstrommessgrößen eine Rolle, die vorzugsweise in den in den Wechselstrommesskreis eingeprägten Wechselstromgrößen wiedergegeben ist. D.h., dass die Wechselstromgrößen vorzugsweise dieselbe Phasenlage zueinander haben, wie die Wechselstrommessgrößen, insbesondere dass die Phasenlage zwischen Wechselstrommessspannung und Wechselstrommessstrom gleich ist, wie die Phasenlage zwischen Wechselspannung und Wechselstrom im Wechselstrommesskreis.

Als Normzähler kommen beispielsweise Ferraris-Zähler oder Smart Meter zum Einsatz, welche insbesondere für sehr kleine Leistungen ausgelegt sind, insbesondere Leistungen die um einen Faktor 1000 bis 5000 kleiner sind, als die Leistungen, die in dem Wechselstromladekreis relevant sind. Vorzugsweise sind diese Normzähler auch für andere Frequenzen ausgelegt, als die Frequenz in dem Wechselstromladekreis.

Durch geeignete Skalierung der Wechselstromgröße gegenüber der Wechselstrommessgröße ist es möglich, die in dem Wechselstrommesskreis gemessene Wechselstromgröße, insbesondere die Wirkleistung, um einen konstanten Faktor geringer zu halten, als die Wirkleistung, die über den Wechselstromladekreis zur Verfügung gestellt wird. Umrechnungsfaktoren von 1000 oder 5000 sind durchaus denkbar. Entsprechende Wechselstrommessgeräte sind verfügbar, welche eine entsprechende Hochskalierung durchführen und die gemessene elektrische Wirkleistung in dem Wechselstrommesskreis um den bekannten Faktor multipliziert als gemessene elektrische Leistung, respektive unter Berücksichtigung der Zeit, als elektrische Energie ausgeben.

Der Wandler verfügt in der Regel über einen konstanten Umrechnungsfaktor, beispielsweise einem dem Zähler entsprechenden Umrechnungsfaktor. Je nachdem, wie die Umrechnung in dem Wechselstromzähler erfolgt, kann eine Einstellung der Wechselstromstellgröße abhängig von der Wechselstrommessgröße erfolgen.

Gemäß einem Ausführungsbeispiel wird vorgeschlagen, dass der Wandler derart eingerichtet ist, dass der Betrag der Wechselstromgröße um zumindest einen Faktor 10 kleiner ist, als der Betrag der Wechselstrommessgröße. Bevorzugt sind jedoch Faktoren von 100, beispielsweise 1000 oder gar 5000. Entsprechende Wechselstrommessgeräte sind verfügbar, die um einen entsprechenden Faktor multipliziert die gemessene Wechselstromgröße ausgeben. Somit ist am Wechselstrommessgerät die Ausgabe des Messwertes entsprechend der Wechselstrommessgröße, obwohl von Wechselstrommessgröße zu Wechselstromgröße zunächst eine Skalierung nach unten stattgefunden hat. Diese Skalierung wird in dem Wechselstrommessgerät entsprechend kompensiert.

Um zu gewährleisten, dass in dem Wechselstrommesskreis vorzugsweise Wirkleistung verbraucht wird, kann der Wechselstrommesskreis hinsichtlich parasitärer kapazitiver oder induktiver Lasten optimiert werden. Vorzugsweise ist in dem Wechselstrommesskreis lediglich ein ohmscher Widerstand vorgesehen. Die elektrische Wirkleistung ist vorzugsweise um einen Faktor geringer als die elektrische Leistung im Wechselstromladekreis.

Gemäß einem Ausführungsbeispiel wird vorgeschlagen, dass der Abgriff parallel zu zumindest einem Messwiderstand angeordnet ist. Die Wechselstrommessgröße, insbesondere der Wechselstrom in dem Wechselstromladekreis, wird vorzugsweise über einen ohmschen Widerstand, insbesondere ein Messwiderstand erfasst. Der Messwiderstand unterliegt Temperaturschwankungen, so dass die über den Spannungsabfall über den Messwiderstand ermittelte Stromstärke temperaturabhängig sein kann. Um im Wechselstrommesskreis eine Temperaturkompensation durchführen zu können, wird neben den Wechselstrommessgrößen vorzugsweise gemäß einem Ausführungsbeispiel auch eine Temperatur in dem Wechselstromladekreis erfasst. Die Temperatur wird vorzugsweise über einen Temperatursensor erfasst. Die Temperatur wird vorzugsweise am Messwiderstand erfasst. Der Temperatursensor ist vorzugsweise an dem Wechselstromladekreis angeordnet. Der Temperatursensor ist vorzugsweise unmittelbar an dem Messwiderstand angeordnet und erfasst somit die Temperatur des Messwiderstands. Die Wechselstromgröße wird dann zusätzlich abhängig von der gemessenen Temperatur des Temperatursensors bestimmt. Somit ist es möglich, die aufgrund des Spannungsabfalls über dem Messwiderstand ermittelte Stromstärke des Wechselstromladekreises temperaturkompensiert in dem Wechselstrommesskreis zur Verfügung zu stellen.

Die gemessene Wechselstrommessgröße, insbesondere die Wechselspannung als auch der Wechselstrom, können in einem Skalierer zunächst skaliert werden, um beispielsweise einem Analog-Digital-Wandler zugeführt zu werden. Der Analog-Digital-Wandler verfügt in der Regel über eine begrenzte Auflösung. Um Fehler aufgrund von ungenauen Quantisierungen auszuschließen, wird vorgeschlagen, über einen Operationsverstärker zunächst eine Skalierung der Wechselstrommessgrößen durchzuführen, um deren Wertedynamik, insbesondere die Amplitude der Messwerte, zu verringern.

Gemäß einem Ausführungsbeispiel wird vorgeschlagen, dass über dem Abgriff als Wechselstrommessgrößen zumindest ein Betrag des Wechselstroms im Wechselstromladekreis und ein Betrag einer Spannung, insbesondere über einen Energiespeicher im Wechselstromladekreis erfassbar sind. Um einen Gleichlauf der Wirkleistung in dem Wechselstrommesskreis mit der Wirkleistung in dem Wechselstromladekreis zu ermöglichen, kann in dem Wechselstrommesskreis eine Messung der Wechselspannung als auch des Wechselstroms erfolgen. Bei dieser Messung kann außerdem ein Phasenwinkel zwischen dem Wechselstrom und der Wechselspannung bestimmt werden. Eine hieraus abgeleitete Information über eine Wirkleistung in dem Wechselstrommesskreis kann zu dem Wandler zurückgekoppelt werden. Dort kann dieser Wert als Rückführung zu der Führungsgröße der Wechselstrommessgröße, um die Wechselstromgröße einzustellen, dienen. Die in dem Wechselstrommesskreis gemessenen Wechselstromgrößen können gemeinsam oder auch unabhängig voneinander an den Wandler zurückgekoppelt werden, um so eine Regelung der Wechselstromgröße respektive der Wechselstromstellgröße zu ermöglichen.

Die Frequenz in dem Wechselstromladekreis ist vorzugsweise abweichend von einer Normfrequenz eines Energieversorgungsnetzes. Es wird vorgeschlagen, dass eine Frequenz der Wechselstromgrößen in dem Wechselstrommesskreis, insbesondere 50 Hz oder 60 Hz mit einer Varianz von +-3% ist.

Um in dem Wechselstrommesskreis eine möglichst exakte Messung der Wechselstromleistung zu ermöglichen, wird vorgeschlagen, dass in dem Wechselstrommesskreis eine Konstantstromquelle vorgesehen ist. Die Konstantstromquelle wird abhängig von der Wechselstromstellgröße eingestellt. Über die Konstantstromquelle fließt ein konstanter Wechselstrom in den Wechselstrommesskreis, der zusammen mit der Wechselspannung in dem Messgerät gemessen wird und somit eine Wirkleistung und bzw. unter Berücksichtigung der Zeit eine Wirkenergie gemessen wird.

Die Konstantstromquelle ist vorzugsweise ein einstellbarer Widerstand, bzw. weist einen solchen einstellbaren Widerstand auf. Mit Hilfe des einstellbaren Widerstands ist es möglich den Stromfluss in den Wechselstrommesskreis einzustellen. Wird der Wechselstrommesskreis beispielsweise mit 230 V betrieben, so kann durch geeignete Einstellung des Widerstands ein Stromfluss in dem Wechselstrommesskreis, abhängig von dem Stromfluss in dem Wechselstromladekreis, beispielsweise 200 mA sein. omit ergibt sich eine Wirkleistung von 46 W in dem Wechselstrommesskreis. Diese Wirkleistung wird durch das Wechselstrommessgerät gemessen und eine Wirkenergie wird ausgegeben.

Eine Wirkleistung von 46 W kann bei einem Skalierungsfaktor von 1000, wie er beispielsweise in dem Wandler eingestellt werden kann, einer Wechselstromleistung in dem Wechselstromladekreis von 46 kW entsprechen. D.h., dass wenn ein Elektrofahrzeug mit 46 kW in dem Wechselstromladekreis lädt, der Wechselstrommesskreis entsprechend nur 46 W "Messleistung" verbraucht. Ein noch höherer Faktor führt zu einem noch geringeren Verbrauch an "Messleistung" in dem Wechselstrommesskreis, was die Wirtschaftlichkeit des Messwandlers erhöht.

Gemäß einem Ausführungsbeispiel wird vorgeschlagen, dass der Wandler derart die Wechselstromgröße einstellt, dass die elektrische Wirkleistung in dem Wechselstromkreis einen konstanten Faktor kleiner ist, als die elektrische Leistung in dem Wechselstromladekreis. Der Faktor ist, wie erwähnt, vorzugsweise über ein 100, insbesondere über 1000, oder 5000. Der Faktor kann insbesondere abhängig von der Art des Energiezählers in den Wechselstrommesskreis sein. Wird ein Energiezähler mit einem Faktor 5000 eingesetzt, kann der Faktor über den Wandler entsprechend auch auf 5000 gesetzt sein.

Um die elektrische Leistung in dem Messkreis möglichst gering zu halten, wird vorgeschlagen, dass der Wechselstrommesskreis als einphasiger Wechselstrommesskreis ist.

Ein weiterer Aspekt ist ein Verfahren nach Anspruch 15.

Die Wechselstrommessgröße wird vorzugsweise in kurzen Intervallen erfasst, um die die erfasste momentane elektrische Leistung möglichst zeitgenau abbilden zu können. Nur dann ist die gemessene elektrische Energie auch möglichst exakt ein Abbild der zur Verfügung gestellten elektrischen Energie. Aus diesem Grunde wird vorgeschlagen, dass die Intervalle kleiner 1 Sekunde, vorzugsweise kleiner 100 ms, insbesondere 10 ms sind.

Für den Stand der Technik relevante Dokumente sind US 5 574 362, WO 2010/149450 und US 2011/285349.

Nachfolgend wird der Gegenstand anhand einer Ausführungsbeispiele zeigenden Zeichnung näher erläutert. In der Zeichnung zeigen:
- Fig. 1: einen Wechselstromladekreis in einem Elektrofahrzeug;
- Fig. 2: einen Wandler;
- Fig. 3: einen Wechselstrommesskreis.

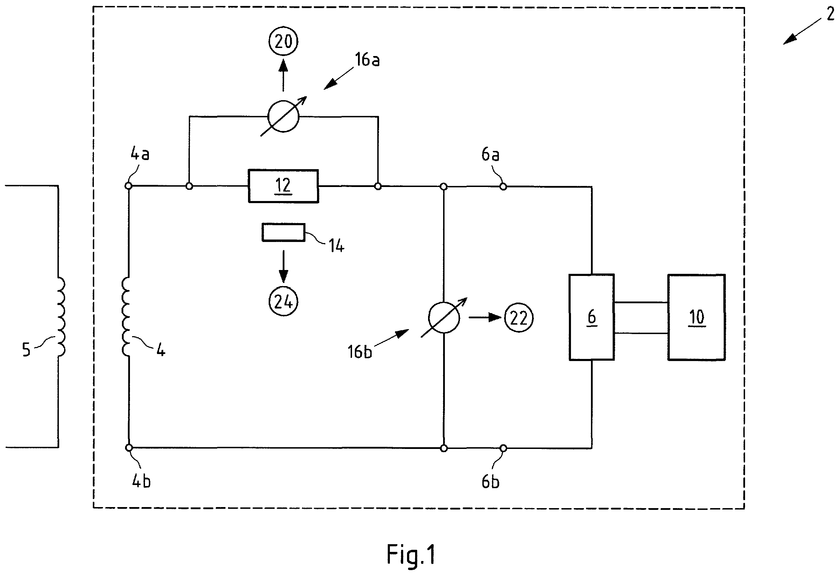

Fig. 1 zeigt schematisch den Aufbau in einem Elektrofahrzeug 2 mit einer Induktionsspule 4. An der Induktionsspule 4 liegt an den Anschlüssen 4a, 4b eine Wechselspannung an, über die ein Energiespeicher des Elektrofahrzeugs geladen werden kann. Hierzu schließt sich an den Wechselstromladekreis ein AC/DC Wandler 6 an, der zur Speisung des Energiespeichers 10 eingerichtet ist. Über einen Ladecontroller lässt sich der Ladevorgang in dem Wechselstromladekreis 8 einstellen, insbesondere kann der Wechselstrom in dem Wechselstromladekreis 8 eingestellt werden. Der Wechselstromladekreis 8 wird in der Regel für Leistungen von mehr als 10 kW, vorzugsweise mehr als 40 kW, insbesondere mehr als 70 kW elektrische Leistung ausgelegt. Die Induktionsspule 4 ist mit einer Erregerspule 5 einer Ladestation gekoppelt und elektrische Leistung wird über die magnetische Kopplung in den Wechselstromladekreis 8 eingekoppelt.

Der Wechselstromladekreis 8 ist zum Zwecke der Übersichtlichkeit nur mit den für den gegenständlichen Messwandler relevanten Messeinrichtungen gezeigt. Das Laden eines Elektrofahrzeugs 8 erfordert naturgemäß weitere technische Einrichtungen, die der Übersichtlichkeit halber hier jedoch nicht gezeigt sind.

In dem Wechselstromladekreis 8 ist ein Messwiderstand 12 vorgesehen. Der Messwiderstand 12 ist in der Regel ein Messshunt, der möglichst über einen weiten Temperaturbereich ein konstantes Strom/Spannungsverhalten aufweist. Der Messshunt kann z.B. aus Manganin gebildet sein.

Über den Messwiderstand 12 wird die abfallende Spannung mit einem Spannungsmesser 13 abgegriffen. Aus diesem Spannungswert lässt sich die Stromstärke in dem Wechselstromladekreis 8 ableiten, wenn sowohl Temperatur als auch die Strom-Spannungskennlinie des Messwiderstands 12 bekannt ist. Dieser Wert wird als Wechselstrommesswert 20 ausgegeben.

Ferner wird eine Wechselspannung durch einen Spannungsmesser 16b über der Last 6 gemessen und als Wechselspannungsmesswert 22 ausgegeben.

Darüber hinaus ist ein Temperatursensor 14 vorgesehen, der vorzugsweise unmittelbar an den Messwiderstand 12 angeordnet ist und somit vorzugsweise die Temperatur des Messwiderstandes 12 misst. Der Temperatursensor 14 gibt einen Temperaturmesswert 24 aus.

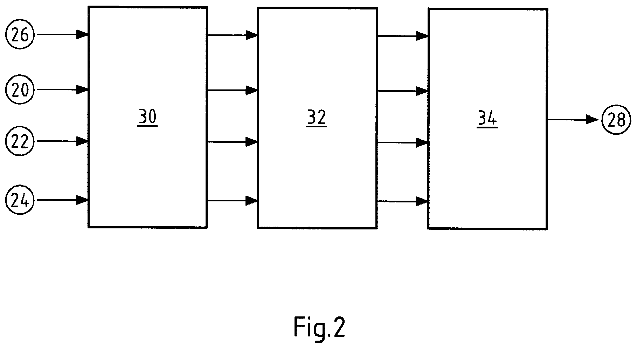

Die in dem Wechselstromladekreis 8 gemessenen Messwerte werden anschließend zunächst einer Skaliervorrichtung 30, wie in Figur 2 gezeigt, zugeführt.

In der Skaliervorrichtung 30 werden insbesondere der Wechselstrommesswert 20 als auch der Wechselspannungsmesswert 22 skaliert, um insbesondere eine betragsmäßig geringere Amplitude der Messwerte sicher zu stellen. Die Skalierung kann für einen, mehrere oder alle Messwerte erfolgen. Darüber hinaus wird dem Skalierer 30 ein Leistungsmesswert 26 rückgekoppelt, welcher wie nachfolgend beschrieben erfasst wird.

Alle Messwerte werden anschließend einem Analog-Digital Wandler 32 zugeführt und die dann digitalisierten Messwerte werden anschließend einem Wandler 34 zugeführt. In dem Wandler 34 erfolgt die Umwandlung der Wechselstrommesswerte in Abhängigkeit des Temperaturmesswerts 24 und des rückgekoppelten Leistungsmesswertes 26 in einen Wechselstromstellwert 28.

Zunächst werden der Wechselspannungsmesswert 22 und der Wechselstrommesswert 20 verwendet, um eine elektrische Leistung in dem Wechselstromladekreis 8 zu bestimmen. Anschließend oder davor kann der Temperaturmesswert 24 verwendet werden, um aus dem Wechselstrommesswert 20 eine Temperaturdrift auszurechnen. Hat der Messwiderstand 12 nicht über den gesamten Temperaturbereich eine konstante Strom/Spannungskennlinie, so kann eine Temperaturdrift aufgrund des Temperaturmesswerts berücksichtigt werden und so aus der über den Widerstand 12 gemessenen Spannung der tatsächlich in dem Wechselstromladekreis 8 fließende Wechselstrom bestimmt werden. Temperaturbereinigt kann dann die Ladeleistung in dem Wechselstromladekreis 8 bestimmt werden.

Darüber hinaus kann die Frequenz in dem Wechselstromladekreis 8 bestimmt werden. Ferner kann die Phasenlage aus Ladestrom und Ladespannung bestimmt werden umso die Wirkleistung in dem Ladekreis 8 zu bestimmen.

Abhängig von einem Faktor, beispielsweise 1.000, kann eine Wechselstromstellgröße bestimmt werden. Der Faktor kann beispielsweise auf die Ladeleistung angewendet werden. Ergibt sich beispielsweise eine Ladeleistung von 1 kW wird die Wechselstromstellgröße bei einem Faktor von 1.000 zu 1 W. Es erfolgt vorzugsweise eine lineare Umrechnung der Wechselstrommessgröße in eine Wechselstromstellgröße.

Die Wechselstromstellgröße 28 wird am Wandler 34 ausgegeben und beispielsweise verwendet, um eine Umrechnung in einen Wechselstrom bei einer Normfrequenz durchzuführen.

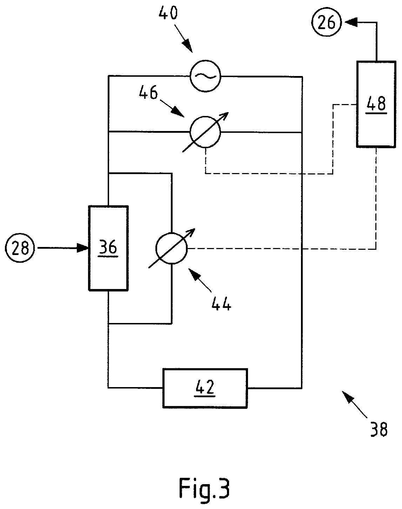

Die Wechselstromstellgröße 28 wird, wie in Figur 3 gezeigt, einer Konstantstromquelle 36 zugeführt. Die Konstantstromquelle 36 verfügt in der Regel über einstellbaren Widerstand. Über den Widerstand lässt sich der Strom über die Konstantstromquelle 36 einstellen. Der Widerstand, der in der Konstantstromquelle 36 eingestellt wird, bestimmt sich aus der Spannung in dem Wechselstrommesskreis 38 und der Wechselstromstellgröße 28. Ist beispielsweise die elektrische Leistung in dem Ladekreis 8 23 kW ergibt sich bei einem Faktor von 1.000 in dem Wandler 34 eine Wechselstromleistung von 23 W. Bei einer Wechselspannung von 230 V AC bei Normfrequenz ergibt sich hieraus bei einem Leistungsfaktor cosphi von 1 eine Wechselstromgröße von 0,1 Ampere. Diese Stromstärke führt zu einer Einstellung des Widerstandes in der Konstantstromquelle 36 auf 2,3 kΩ. Es sei erwähnt, dass dies rein beispielhaft ist und abhängig vom Faktor und weiteren Randbedingungen die Konstantstromquelle 36 auch mit anderen Werten betrieben werden kann.

Die Frequenz der Wechselstromgrößen wird dabei vorzugsweise auf einen Normwert von 50 Hz oder 60 Hz eingestellt.

Der Wechselstrommesskreis 38 ist insbesondere ein einphasiger Messkreis und verfügt neben der Konstantstromquelle 36 über einen Normzähler 42. Der Normzähler 42 erfasst insbesondere die elektrische Wirkleistung beziehungsweise Wirkenergie, die in dem Wechselstrommesskreis 38 bei Normfrequenz verbraucht wird. Hierbei ist zu beachten, dass der Normzähler 42 als Stromzähler auf eine Normfrequenz eingestellt ist und nur bei Normfrequenz korrekt misst. Die Normfrequenz ist in der Regel 50Hz oder 60 Hz, je nach elektrischem Energieversorgungsnetz.

In dem oben genannten Beispiel ist die Leistung beispielsweise 23 W. Wenn diese über eine Stunde konstant anfällt, das heißt wenn das Fahrzeug beispielsweise mit 23 kW über eine Stunde konstant lädt, und somit eine elektrische Energie von 23 kWh bezogen hat, misst der Normzähler 42 23 Wh. Der ausgegebene Messwert könnte jedoch 23 kWh sein, wenn der Energiemengenzähler 42 einen entsprechenden Umrechnungsfaktor von 1.000 hat.

Zur Kontrolle der in dem Wechselstrommesskreis 38 verbrauchten Wirkleistung in Relation zu der elektrischen Leistung in dem Wechselstromladekreis 8 wird ein Strom und eine Spannung in dem Wechselstrommesskreis 38 erfasst. Der Strom in dem Wechselstrommesskreis 38 wird vorzugsweise über einen Spannungsmesser 44, der den Spannungsabfall über die Konstantstromquelle 36 misst, erfasst. Die Wechselspannung wird über einen Spannungsmesser 46 erfasst. Außerdem kann ein Phasenwinkel zwischen Strom und Spannung erfasst werden. Die hieraus abgeleiteten Messwerte werden einer Auswerteschaltung 48 zugeführt und in der Auswerteschaltung 48 wird anhand der gemessenen Werte die in dem Wechselstrommesskreis 38 verbrauchte Wirkleistung bestimmt. Diese Wirkleistung kann als Leistungsmesswert 26 ausgekoppelt werden und wie in Figur 2 gezeigt, dem Skalierer 30 zugeführt werden.

Letztendlich wird der Leistungsmesswert 26 dem Wandler 34 zugeführt und kann mit der Wechselstromstellgröße verglichen werden. Diese beiden Werte müssen miteinander übereinstimmen, ansonsten kann in dem Wandler 34 eine Regelung, insbesondere eine P-Regelung, eine PI-Regelung oder eine PID-Regelung erfolgen um so einen Gleichlauf aus der gemessenen Wechselstrommessgröße und der eingestellten Wechselstromsgröße zu erzielen.

Mit Hilfe des gegenständlichen Messwandlers ist es möglich, in besonders einfacher und kostengünstiger Weise für Abrechnungszwecke relevante Messwerte bei einem Normzähler bei Normfrequenz zu erfassen.

### Bezugszeichenliste

- 2: Fahrzeug
- 4: Spule
- 4a,b: Anschlüsse
- 6: Gleichrichter
- 8: Ladekreis
- 10: Energiespeichers
- 12, 16: Spannungsmesser
- 14: Temperatursensor
- 20: Wechselstrommesswert
- 22: Wechselspannungsmesswert
- 24: Temperaturmesswert
- 26: Leistungsmesswert
- 28: Wechselstromstellwert
- 30: Skalierer
- 32: Analog-Digital Wandler
- 34: Wandler
- 36: Konstantstromquelle
- 38: Wechselstrommesskreis
- 40: Wechslestromquelle
- 42: Normzähler
- 44: Spannungsmesser
- 46: Spannungsmesser
- 48: Auswerteschaltung

## Patentansprüche

1. Elektrofahrzeug (2) mit
- einer Induktionsspule (4) in einem Wechselstromladekreis zur induktiven Kopplung mit einer Ladestation und zum Empfangen von elektrischer Leistung über eine Erregerspule zum Laden eines Energiespeichers (10), und
- einem Messwandler umfassend
- zumindest einen Abgriff eingerichtet zum Abgreifen zumindest einer Wechselstrommessgröße (20, 22) in einem die Induktionsspule (4) aufweisenden Wechselstromladekreis,
- einen Wandler (6) eingerichtet zum Umsetzen einer Frequenz der Wechselstrommessgröße (20, 22) in eine Normfrequenz eines Energieversorgungsnetzes, und zur Ausgabe zumindest einer Wechselstromgröße mit der Normfrequenz in einem Wechselstrommesskreis (38), und
- zumindest einen im Wechselstrommesskreis (38) angeordneten Normmesszähler (42) zur Erfassung einer elektrischen Leistung mit der Wechselstromgröße bei der Normfrequenz.

2. Elektrofahrzeug (2) nach Anspruch 1,
**dadurch gekennzeichnet,**
- **dass** der Wechselstromladekreis zumindest eine Induktionsspule (4) als als Konstantspannungsquelle aufweist.

3. Elektrofahrzeug (2) nach Anspruch 1 oder 2,
**dadurch gekennzeichnet,**
- **dass** der Wandler (6) eine Wechselstromstellgröße (28) zumindest abhängig von der Wechselstrommessgröße (20, 22) einstellt und die Wechselstromgröße abhängig von der Wechselstromstellgröße (28) ausgibt, insbesondere
- **dass** der Wandler (6) derart eingerichtet ist, dass der Betrag der Wechselstromgröße um zumindest einen Faktor zehn kleiner ist als der Betrag der Wechselstrommessgröße (20, 22).

4. Elektrofahrzeug (2) nach einem der vorangehenden Ansprüche,
**dadurch gekennzeichnet,**
- **dass** die zumindest eine Wechselstrommessgröße (20, 22) zumindest eine Wechselspannung und/oder einen Wechselstrom umfasst und dass die zumindest eine Wechselstromgröße zumindest eine Wechselspannung und/oder einen Wechselstrom bei Normfrequenz umfasst.

5. Elektrofahrzeug (2) nach einem der vorangehenden Ansprüche,
**dadurch gekennzeichnet,**
- **dass** die erfasste elektrische Leistung eine elektrische Wirkleistung ist.

6. Elektrofahrzeug (2) nach einem der vorangehenden Ansprüche,
**dadurch gekennzeichnet,**
- **dass** der Normmesszähler (42) insbesondere ein Ferraris-Zähler oder ein Smart Meter ist.

7. Elektrofahrzeug (2) nach einem der vorangehenden Ansprüche,
**dadurch gekennzeichnet,**
- **dass** der Abgriff parallel zu zumindest einem Messwiderstand (12) angeordnet ist.

8. Elektrofahrzeug (2) nach einem der vorangehenden Ansprüche,
**dadurch gekennzeichnet,**
- **dass** über den Abgriff als Wechselstrommessgrößen (20, 22) zumindest ein Betrag des Wechselstroms im Wechselstromladekreis und ein Betrag einer Spannung über einen Energiespeicher (10) im Wechselstromladekreis erfassbar sind.

9. Elektrofahrzeug (2) nach einem der vorangehenden Ansprüche,
**dadurch gekennzeichnet,**
- **dass** eine Frequenz in dem Wechselstromladekreis von einer Normfrequenz eines Energieversorgungsnetzes abweicht und dass die Normfrequenz in dem Wechselstrommesskreis (38) insbesondere 50Hz oder 60Hz +/- 3% ist.

10. Elektrofahrzeug (2) nach einem der vorangehenden Ansprüche,
**dadurch gekennzeichnet,**
- **dass** der Wechselstrommesskreis (38) eine Konstantstromquelle (36) aufweist und dass die Konstantstromquelle (36) abhängig von der Wechselstromstellgröße (28) einen konstanten Wechselstrom in den Wechselstrommesskreis (38) speist.

11. Elektrofahrzeug (2) nach einem der vorangehenden Ansprüche,
**dadurch gekennzeichnet,**
- **dass** die Konstantstromquelle (36) zumindest einen abhängig von der Wechselstromstellgröße (28) einstellbaren Widerstand aufweist.

12. Elektrofahrzeug (2) nach einem der vorangehenden Ansprüche,
**dadurch gekennzeichnet,**
- **dass** der Wandler (6) derart die Wechselstromgröße einstellt, dass die elektrische Wirkleistung in dem Wechselstrommesskreis (38) einen konstanten Faktor kleiner ist als die elektrische Leistung in dem Wechselstromladekreis.

13. Elektrofahrzeug (2) nach einem der vorangehenden Ansprüche,
**dadurch gekennzeichnet,**
- **dass** der Wechselstrommesskreis (38) ein einphasiger Wechselstromkreis ist.

14. Ladestation mit
- einer Erregerspule in einem Wechselstromladekreis zur induktiven Kopplung mit einem Elektrofahrzeug (2) und zum Speisen einer Induktionsspule (4) des Elektrofahrzeugs (2), und
- einem Messwandler umfassend
- zumindest einen Abgriff eingerichtet zum Abgreifen zumindest einer Wechselstrommessgröße (20, 22) in einem die Erregerspule aufweisenden Wechselstromladekreis,
- einen Wandler (6) eingerichtet zum Umsetzen einer Frequenz der Wechselstrommessgröße (20, 22) in eine Normfrequenz eines Energieversorgungsnetzes, und zur Ausgabe zumindest einer Wechselstromgröße mit der Normfrequenz in einem Wechselstrommesskreis (38), und
- zumindest einen im Wechselstrommesskreis (38) angeordneten Normmesszähler (42) zur Erfassung einer elektrischen Leistung mit der Wechselstromgröße bei der Normfrequenz.

15. Verfahren zum Betreiben eines Elektrofahrzeugs oder einer Ladestation, insbesondere nach einem der vorangehenden Ansprüche, bei dem
- in einem eine Induktionsspule (4) eines Elektrofahrzeugs (2) oder eine Erregerspule einer Ladestation aufweisenden Wechselstromladekreis zumindest eine Wechselstrommessgröße (20, 22) gemessen wird, und
- ein Wechselstrommesskreis (38) mit einer Wechselstromgröße betrieben wird, **dadurch gekennzeichnet,**
- **dass** die Wechselstromgröße mit einer von der Frequenz des Wechselstromladekreises verschiedenen Normfrequenz in den Wechselstrommesskreis (38) eingespeist wird, und
- **dass** in dem Wechselstrommesskreis (38) ein Normmesszähler (42) die Wechselstromgröße bei der Normfrequenz erfasst.

## Claims

1. Electric vehicle (2) with
- an induction coil (4) in an AC charging circuit for inductive coupling with a charging station and for receiving electrical power via an excitation coil for charging an energy storage (10), and
a measuring transducers comprising:
- at least one tap arranged to tap at least one AC measured value (20, 22) in an AC charging circuit which comprises the induction coil (4),
- a converter (6) arranged for converting a frequency of the AC measured value (20, 22) into a standard frequency of a energy supply grid, and for outputting at least one AC value with the standard frequency into an AC measuring circuit (38), and
- at least one standard meter (42) arranged in the AC measuring circuit (38) for obtaining an electrical power using the AC value at the standard frequency.

2. Electric vehicle (2) according to claim 1,
**characterized in that**
- the AC charging circuit has at least one induction coil (4) as a constant voltage source.

3. Electric vehicle (2) according to claim 1 or 2,
**characterized in that**
- the converter (6) sets an AC control value (28) at least as a function of the AC measured value (20, 22) and outputs the AC value as a function of the AC control value (28) in particular that
- the converter (6) is arranged in such a way that the absolute value of the AC value is smaller by at least a factor of ten than the absolute value of the AC measured value (20, 22).

4. Electric vehicle (2) according to one of the preceding claims,
**characterized in that**
- the at least one AC measured value (20, 22) comprises at least one alternating voltage and/or one alternating current and **in that** the at least one AC value comprises at least one alternating voltage and/or one alternating current at standard frequency.

5. Electric vehicle (2) according to one of the preceding claims,
**characterized in that**
- that the electrical power measured is an active electrical power.

6. Electric vehicle (2) according to one of the preceding claims,
**characterized in that**
- that the standard meter (42) is in particular a Ferraris Meter or a Smart Meter.

7. Electric vehicle (2) according to one of the preceding claims,
**characterized in that**
- the tap is arranged parallel to at least one measuring resistor (12).

8. Electric vehicle (2) according to one of the preceding claims,
**characterized in that**
- at least one absolute value of the alternating current in the AC charging circuit and an absolute value of a voltage across an energy storage (10) in the AC charging circuit can be detected via the tap as AC measured values (20, 22).

9. Electric vehicle (2) according to one of the preceding claims,
**characterized in that**
- a frequency in the AC charging circuit deviates from a standard frequency of an energy supply grid and **in that** the standard frequency in the AC measuring circuit (38) is in particular 50Hz or 60Hz +/- 3%.

10. Electric vehicle (2) according to one of the preceding claims,
**characterized in that**
- the AC current measuring circuit (38) has a constant current source (36) and **in that** the constant current source (36) feeds a constant alternating current into the AC current measuring circuit (38) as a function of the AC current control value (28).

11. Electric vehicle (2) according to one of the preceding claims,
**characterized in that**
- the constant current source (36) has at least one resistance which can be set as a function of the AC control value (28).

12. Electric vehicle (2) according to one of the preceding claims,
**characterized in that**
- the converter (6) sets the AC value in such a way that the active electrical power in the AC measuring circuit (38) is a constant factor smaller than the electrical power in the AC charging circuit.

13. Electric vehicle (2) according to one of the preceding claims,
**characterized in that**
- that the AC measuring circuit (38) is a single-phase AC circuit.

14. Charging station with
- an excitation coil within an AC charging circuit and arranged for inductive coupling with an electric vehicle (2) and for feeding an induction coil (4) of the electric vehicle (2) and a measuring transducers comprising:
- at least one tap arranged to tap at least one AC measured value (20, 22) in an AC charging circuit which comprises the induction coil (4),
- a converter (6) arranged for converting a frequency of the AC measured value (20, 22) into a standard frequency of a energy supply grid, and for outputting at least one AC value with the standard frequency into an AC measuring circuit (38), and
- at least one standard meter (42) arranged in the AC measuring circuit (38) for obtaining an electrical power using the AC value at the standard frequency.

15. Method for operating an electric vehicle or a charging station,, in particular according to one of the preceding claims, in which
- at least one AC measured value (20, 22) is measured in an AC charging circuit comprising an induction coil (4) of an electric vehicle (2) or an excitation coil of a charging station, and
- an AC measuring circuit (38) is operated using an AC value,
**characterized in that**
- the AC value is fed into the AC measuring circuit (38) at a standard frequency which is different from the frequency of the AC charging circuit, and
- within the AC measuring circuit (38), a standard meter (42) obtains the AC value at the standard frequency.

## Revendications

1. Véhicule électrique (2) avec
- une bobine d'induction (4) dans un circuit de charge à courant alternatif pour un couplage inductif avec une station de charge et pour une réception d'énergie électrique via une bobine d'excitation pour charger un dispositif de stockage d'énergie (10), et
- un transducteur de mesure comprenant
- au moins une prise configurée à prélever au moins une quantité mesurée de courant alternatif (20, 22) dans un circuit de charge à courant alternatif comprenant la bobine d'induction (4),
- un convertisseur (6) configuré à convertir une fréquence de la quantité mesurée de courant alternatif (20, 22) en une fréquence standard d'un réseau d'alimentation en énergie, et pour délivrer au moins une variable de courant alternatif avec la fréquence standard à un circuit de mesure de courant alternatif (38), et
- au moins un compteur standard (42) disposé dans le circuit de mesure de courant alternatif (38) pour détecter une puissance électrique au moyen de la quantité de courant alternatif à la fréquence standard.

2. Véhicule électrique (2) selon la revendication 1,
**caractérisé en ce**
- **que** le circuit de charge à courant alternatif comprend au moins une bobine d'induction (4) comme source de tension constante.

3. Véhicule électrique (2) selon la revendication 1 ou 2,
**caractérisé en ce**
- **que** le convertisseur (6) règle une quantité de commande de courant alternatif (28) au moins en fonction de la quantité de mesure de courant alternatif (20, 22) et délivre la quantité de courant alternatif en fonction de la quantité de commande de courant alternatif (28), en particulier
- **que** le convertisseur (6) est configuré de telle sorte que la valeur absolue de la quantité de courant alternatif est inférieure à la valeur absolue de la quantité mesurée de courant alternatif (20, 22) d'au moins un facteur dix.

4. Véhicule électrique (2) selon l'une des revendications précédentes,
**caractérisé en ce**
- **que** la au moins une quantité de mesure de courant alternatif (20, 22) comprend au moins une tension alternative et/ou un courant alternatif, et que la au moins une quantité de mesure de courant alternatif comprend au moins une tension alternative et/ou un courant alternatif à fréquence standard.

5. Véhicule électrique (2) selon l'une des revendications précédentes,
**caractérisé en ce**
- **que** la puissance électrique détectée est une puissance électrique active.

6. Véhicule électrique (2) selon l'une des revendications précédentes,
**caractérisé en ce**
- **que** le compteur standard (42) est, en particulier, un compteur Ferraris ou un Smart Meter.

7. Véhicule électrique (2) selon l'une des revendications précédentes,
**caractérisé en ce**
- **que** la prise est disposée en parallèle avec au moins une résistance de mesure (12).

8. Véhicule électrique (2) selon l'une des revendications précédentes,
**caractérisé en ce**
- **qu'**au moins une valeur absolue du courant alternatif dans le circuit de charge à courant alternatif et une valeur absolue d'une tension à travers un dispositif de stockage d'énergie (10) dans le circuit de charge à courant alternatif peuvent être détectées via la prise en tant que quantités de mesure de courant alternatif (20, 22).

9. Véhicule électrique (2) selon l'une des revendications précédentes,
**caractérisé en ce**
- **qu'**une fréquence dans le circuit de charge à courant alternatif s'écarte d'une fréquence standard d'un réseau d'alimentation électrique et que la fréquence standard dans le circuit de mesure de courant alternatif (38) est notamment de 50Hz ou 60Hz +/- 3%.

10. Véhicule électrique (2) selon l'une des revendications précédentes,
**caractérisé en ce**
- **que** le circuit de mesure de courant alternatif (38) comprend une source de courant constant (36) et que la source de courant constant (36) injecte un courant alternatif constant dans le circuit de mesure de courant alternatif (38) en fonction de la quantité de commande de courant alternatif (28).

11. Véhicule électrique (2) selon l'une des revendications précédentes,
**caractérisé en ce**
- **que** la source de courant constant (36) comporte au moins une résistance qui peut être ajustée en fonction de la quantité commande de courant alternatif (28).

12. Véhicule électrique (2) selon l'une des revendications précédentes,
**caractérisé en ce**
- **que** le convertisseur (6) règle la quantité de courant alternatif de telle manière que la puissance électrique active dans le circuit de mesure de courant alternatif (38) est plus petit que la puissance électrique dans le circuit de charge de courant alternatif d'un facteur constant.

13. Véhicule électrique (2) selon l'une des revendications précédentes,
**caractérisé en ce**
- **que** le circuit de mesure de courant alternatif (38) est un circuit de courant alternatif monophasé.

14. Station de charge comprenant
- une bobine d'excitation dans un circuit de charge à courant alternatif pour un couplage inductif avec un véhicule électrique (2) et pour alimenter une bobine d'induction (4) du véhicule électrique (2), et
- un transducteur comprenant
- au moins une prise configurée à prélever au moins une quantité de mesure de courant alternatif (20, 22) dans un circuit de charge à courant alternatif comprenant la bobine d'excitation
- un convertisseur (6) configuré à convertir une fréquence de la quantité de mesure de courant alternatif (20, 22) en une fréquence standard d'un réseau d'alimentation en énergie, et pour délivrer au moins une quantité de courant alternatif avec la fréquence standard dans un circuit de mesure de courant alternatif (38), et
- au moins un compteur standard (42) disposé dans le circuit de mesure de courant alternatif (38) pour détecter une puissance électrique au moyen de la quantité de courant alternatif à la fréquence standard.

15. Méthode d'exploitation d'un véhicule électrique ou d'une borne de recharge, notamment selon l'une des revendications précédentes, dans lequel
- au moins une quantité de mesure de courant alternatif (20, 22) est mesurée dans un circuit de charge à courant alternatif comprenant une bobine d'induction (4) d'un véhicule électrique (2) ou une bobine d'excitation d'une station de charge, et
- un circuit de mesure de courant alternatif (38) est actionné avec une quantité de courant alternatif
**caractérisé en ce**
- **que** la quantité de courant alternatif est injectée dans le circuit de mesure de courant alternatif (38) à une fréquence standard qui diffère de la fréquence du circuit de charge à courant alternatif, et
- **qu'**un compteur standard (42) dans le circuit de mesure de courant alternatif (38) détecte la quantité de courant alternatif à la fréquence standard.
